# EUROPEAN PATENT APPLICATION

(11) **EP 4 361 901 A1**
(43) Date of publication of application: **01.05.2024**
(21) Application number: 22882866.1
(22) Date of filing: 18.10.2022
(51) Int. Cl.: G06N 10/00

(54) **SUPERCONDUCTING QUANTUM CIRCUIT AND PREPARATION METHOD THEREFOR, AND QUANTUM COMPUTER**

(30) Priority: 22.10.2021 CN 202111236104
(71) Applicant: Origin Quantum Computing Technology (Hefei) Co., Ltd, Hefei, Anhui 230088 (CN)
(72) Inventor: MA, Liangliang, Hefei, Anhui 230088 (CN); YOU, Bing, Hefei, Anhui 230088 (CN)
(74) Representative: INNOV-GROUP
(86) International application number: PCT/CN2022/125998
(87) International publication number: WO 2023/066261

(57) **Abstract**

A superconducting quantum circuit and a fabrication method thereof, as well as a quantum computer, belong to the field of quantum computing technology. The superconducting quantum circuit comprises a first superconducting element (21) and a second superconducting element (22) formed on a substrate (1), and a superconducting quantum interference device. The superconducting quantum interference device comprises: a bottom electrode (241) integrally connected to the second superconducting element (22); a barrier layer (242) located on the bottom electrode (241); and a top electrode (31) that is electrically connected at one end to the first superconducting element (21) and forms a partial overlapping area with the barrier layer (242) to obtain a Josephson junction at the overlapping area.

## Description

The present application claims the priority to a Chinese patent application No. 202111236104.9 filed with the China National Intellectual Property Administration on October 22, 2021 and entitled "SUPERCONDUCTING QUANTUM CIRCUIT AND FABRICATION METHOD THEREOF, QUANTUM COMPUTER", which is incorporated herein by reference in its entirety.

### Technical field

The present application belongs to the field of quantum information, in particular to the field of quantum computing technology. In particular, the present application relates to a superconducting quantum circuit and a fabrication method thereof, as well as a quantum computer.

### Background

Quantum computing is a new type of computing method that combines quantum mechanics and computer science, which follows the laws of quantum mechanics and regulates quantum information units for calculation. It takes the qubits composed of microscopic particles as basic units, with the characteristics of quantum superposition and entanglement. Moreover, through the controlled evolution of quantum states, quantum computing is able to realize information encoding and computational storage, with a huge information carrying capacity and excellent parallel computing processing capabilities with which classical computing technologies are incomparable. With the increase of the number of qubits, the computing and storage capacity thereof will expand exponentially. This is one of the key development directions in the field of quantum information technology.

Physical systems of quantum computing being explored internationally are developed in the directions of such as ion traps, superconductivity, ultracold atoms, polarized molecules, linear optics, diamond color centers, electrons in silicon 28 or nuclear spins. In recent years, the superconducting technology route has attracted a lot of attention from commercial companies for two reasons: firstly, mankind wants to promote the development of quantum computing with the help of existing very advanced technologies, including semiconductor integrated circuit processes and technologies; and secondly, the advantage of the superconducting system is that it is very scalable.

Currently, the structure of the superconducting quantum circuit in the related art brings numerous inconveniences to the fabrication of the superconducting quantum circuit. Exemplarily, in a superconducting quantum circuit structure, the superconducting quantum interference device and another superconducting element are relatively independent, which makes it often necessary to prepare one of the above two structures, and then prepare the other one of the above two structures. For example, it is often necessary to first prepare a superconducting element to be connected to the superconducting quantum interference device, then prepare a superconducting quantum interference device to be connected to the superconducting element by a process of slant evaporation coating - oxidation - slant evaporation coating, and finally form a structure in which both are electrically connected, the process is lengthy, which greatly hinders the shortening of fabrication period and the improvement of process efficiency.

At present, it is urgent to propose a new superconducting quantum circuit structure to enable efficient process fabrication.

### Summary

To address the deficiencies in the prior art, the present application provides a superconducting quantum circuit and a fabrication method thereof, as well as a quantum computer, to enable efficient process fabrication.

One embodiment of the present application provides a superconducting quantum circuit, comprising a first superconducting element and a second superconducting element formed on a substrate, and a superconducting quantum interference device located between the first superconducting element and the second superconducting element, wherein the superconducting quantum interference device comprises:
a bottom electrode integrally connected to the second superconducting element;
a barrier layer located on the bottom electrode; and
a top electrode that is electrically connected at one end to the first superconducting element and forms a partial overlapping area with the barrier layer to obtain a Josephson junction at the overlapping area.

Optionally, the first superconducting element is a ground layer and the second superconducting element is a capacitor plate having a capacitive effect with respect to the ground layer. Exemplarily, the capacitor plate comprises at least two sub-capacitor plates, and one of the at least two sub-capacitor plates is integrally connected to the bottom electrode.

Optionally, a ground layer is formed on the substrate, and each of the first superconducting element and the second superconducting element is a capacitor plate having a capacitive effect with respect to the ground layer. Exemplarily, the capacitor plates each comprises at least two sub-capacitor plates, and one of the at least two sub-capacitor plates is integrally connected to the bottom electrode, or integrally connected to the top electrode.

Optionally, the at least two sub-capacitor plates are separated from each other.

Optionally, the superconducting quantum interference device comprises at least two top electrodes.

Optionally, the at least two top electrodes are parallel or not parallel to each other.

Optionally, the Josephson junction is a tunnel junction or other structure exhibiting a Josephson effect.

Optionally, the superconducting quantum circuit further comprises a third superconducting element located at a same surface as the first superconducting element and the second superconducting element.

Optionally, the third superconducting element is at least one of a read resonant cavity, a pulse control line, a flux-modulation signal line, and a read signal line.

A second embodiment of the present application provides a fabrication method for a superconducting quantum circuit, wherein the superconducting quantum circuit comprises a first superconducting element and a second superconducting element formed on a substrate, and a superconducting quantum interference device located between the first superconducting element and the second superconducting element, and the fabrication method comprises:
patterning a superconducting material layer formed on the substrate to obtain the first superconducting element, the second superconducting element, and a first electrode integrally connected to the second superconducting element;
oxidizing a surface of the first electrode to obtain a bottom electrode and a barrier layer located on the bottom electrode; and
forming a top electrode that is electrically connected at one end to the first superconducting element and forms a partial overlapping area with the barrier layer to obtain a Josephson junction at the overlapping area.

Optionally, a step of patterning the superconducting material layer formed on the substrate to obtain the first superconducting element, the second superconducting element, and the first electrode integrally connected to the second superconducting element, comprises:
forming a masking layer with a resist pattern on the superconducting material layer, wherein the resist pattern comprises a first resist pattern for defining the first superconducting element, a second resist pattern for defining the second superconducting element, and a third resist pattern for defining the first electrode, and the third resist pattern is connected to the second resist pattern;
etching a portion of the superconducting material layer not covered by the resist pattern to obtain the first superconducting element, the second superconducting element, and the first electrode, wherein the first electrode is integrally connected to the second superconducting element.

Optionally, a step of forming the top electrode that is electrically connected at one end to the first superconducting element and forms the partial overlapping area with the barrier layer, comprises:
forming a masking layer with a deposition window on the superconducting material layer, wherein the deposition window comprises a first window for defining a deposited superconducting material to form the top electrode, and the first window exposes a portion of the first superconducting element as well as a portion of the barrier layer;
depositing a superconducting material and stripping off the masking layer to obtain the top electrode that is electrically connected at one end to the first superconducting element and forms the partial overlapping area with the barrier layer.

A third embodiment of the present application provides a quantum computer, comprising the superconducting quantum circuit, or comprising the superconducting quantum circuit fabricated by the fabrication method.

In contrast to the prior art, the superconducting quantum circuit provided by the present application comprises a first superconducting element, a second superconducting element formed on a substrate, and a superconducting quantum interference device located between the first superconducting element and the second superconducting element, and the superconducting quantum interference device comprises: a bottom electrode integrally connected to the second superconducting element, a barrier layer located on the bottom electrode and a top electrode that is electrically connected at one end to the first superconducting element, and forms a partial overlapping area with the barrier layer to obtain a Josephson junction at the overlapping area. The bottom electrode and the second superconducting element, which are integrally connected in the superconducting quantum circuit provided by the present application, can be fabricated by one patterning process. After the barrier layer is formed on the surface of the bottom electrode, the top electrode partially overlapped with the barrier layer and electrically connected at one end to the first superconducting element can be obtained by one more process such as evaporation coating. Compared to the problems of lengthy fabrication process, long fabrication period and low process efficiency caused by the relatively independent structural forms of the superconducting quantum interference device and other superconducting elements in the prior art, the structure of the superconducting quantum circuit provided in the present application facilitates fabrication and helps to shorten the process flow and improve the fabrication efficiency.

### Brief Description of the Drawings

In order to more clearly illustrate the technical solutions of embodiments of the present application and the prior art, the drawings to be used in the embodiments and the prior art are briefly introduced below. It is obvious that the drawings in the following description are only some of the embodiments of the present application, and for those skilled in the art, other drawings can be obtained based on these drawings without creative efforts.
FIG. 1 shows a schematic structural diagram of a qubit on a superconducting quantum chip in the related art;
FIG. 2A, FIG. 2B, FIG. 2C, and FIG. 2D are schematic diagrams of a fabrication process of a superconducting quantum circuit provided by the present application;
FIG. 3A shows a schematic structural diagram of a first superconducting quantum circuit provided by the present application;
FIG. 3B shows a schematic structural diagram of a second superconducting quantum circuit provided by the present application;
FIG. 3C shows a schematic structural diagram of a second superconducting quantum circuit provided by the present application;
FIG. 4 shows a flowchart of a fabrication method of a superconducting quantum circuit provided by the present application.

Description of the reference signs:
1- substrate, 2-superconducting material layer;
21-ground layer, 22-capacitor plate, 221-first sub-capacitor plate, 222-second sub-capacitor plate, 223-third sub-capacitor plate, 23-electrical connection part, 24-first electrode, 241-bottom electrode, 242-barrier layer, 25-first region, 26-second region, 27-third region, 28-fourth region, 291-first capacitor plate, 292-second capacitor plate;
31-top electrode, 32-pulse signal line, 33-flux-modulation signal line, 34-read resonant cavity, 35-coupling structure.

### Detailed Description

The following detailed description is illustrative only and is not intended to limit the embodiments and/or the present application or use of the embodiments. Furthermore, it is not intended to be constrained by any expressive or implied information presented in the preceding "Background" or "Summary" sections or the "Detailed Description" section.

In order to make the objects, technical solutions, and advantages of the present application more clearly understood, the following is a further detailed description of the present application with reference to the drawings and embodiments. Obviously, the described embodiments are only a part of the embodiments of the present application, and not all of the embodiments. Based on the embodiments in the present application, all other embodiments obtained by those skilled in the art without creative efforts fall within the scope of protection of the present application.

One or more embodiments are now described with reference to the drawings, wherein similar reference signs throughout the text are used to refer to similar components. In the following description, numerous specific details are set forth for explanation in order to provide a more thorough understanding of the one or more embodiments. However, it is obvious that one or more embodiments may be practiced without these specific details in various situations, and various embodiments may be referred to and in conjunction with each other without contradiction.

It should be noted that the terms "first", "second", etc., in the description and claims of the present application and the drawings described above are used to distinguish similar objects and are not necessarily used to describe a specific order or sequence. It should be understood that the data so used may be interchanged under appropriate circumstances, so that the embodiments of the present application described herein can be implemented in an order other than those illustrated or described herein. In addition, the terms "comprising" and "having", and any variations thereof, are intended to cover non-exclusive including, e.g., a process, method, system, product or device comprising a series of steps or units need not be limited to those steps or units that are clearly listed, but may include other steps or units that are not clearly listed or that are inherent to the process, method, product or apparatus.

In addition, it should be understood that when a layer (or film), area, pattern or structure is referred to as being "on" a substrate, layer (or film), area and/or pattern, the layer (or film), area, pattern or structure may be located directly on another layer or substrate, and/or an insertion layer may also be present therebetween. In addition, it should be understood that when a layer is referred to as being "under" another layer, the layer may be located directly under the other layer, and/or one or more insertion layers may also be present therebetween. In addition, references to being "on" and "under" each layer may be made based on the drawings.

Depending on the different physical systems used to construct qubits, the qubits, in terms of physical realization, include superconducting quantum circuits, semiconductor quantum dots, ion traps, diamond vacancies, topological quanta, photons, and so on.

Superconducting quantum computing is the fastest and best way to realize solid-state quantum computing. Since the energy level structure of superconducting quantum circuits can be regulated by applying electromagnetic signals externally, the design and customization of the circuits are highly controllable. At the same time, thanks to the existing mature process of integrated circuits, the superconducting quantum circuits have a scalability that is incomparable by most quantum physics systems. Currently, qubits in the superconducting quantum computing can be anharmonic oscillatory circuits with superconducting elements and capacitors. For example, the capacitor is often a capacitor to ground, e.g., a cross-shaped parallel-plate capacitor. The superconducting element may be a superconducting quantum interference device grounded at one end and connected to the capacitor at the other end.

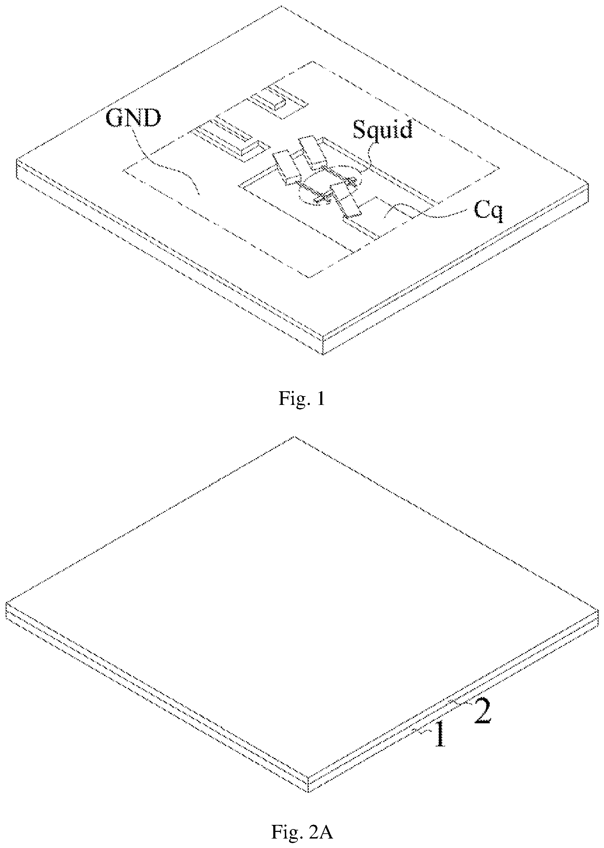

FIG. 1 shows a schematic structural diagram of a qubit on a superconducting quantum chip in the related art.

Referring to FIG. 1, a capacitor plate C_{q} is surrounded by a ground layer (GND) and there is a gap between the capacitor plate C_{q} and the ground layer (GND), and a superconducting quantum interference device (Squid) is connected to the capacitor plate C_{q} at one end, and to the ground layer (GND) at the other end.

In superconducting quantum chips, the capacitor plate of each qubit usually adopts a cross-shaped capacitor plate, a first end of the cross-shaped capacitor plate is usually used for connecting a superconducting quantum interference device Squid, and a second end of the cross-shaped capacitor plate opposite the first end is used for coupling to a read resonant cavity. A certain space is required to be reserved near the first end and the second end for wiring, e.g., a space is required to be reserved near the first end for arranging pulse control lines (also called XY signal lines) and flux-modulation signal lines (also called Z signal lines). The other two ends of the cross-shaped capacitor plate, except the first and second ends described above, are used for coupling to neighboring qubits.

In the superconducting quantum circuit of this form, the superconducting quantum interference device and another superconducting element are relatively independent, which makes it often necessary to prepare one of the above two structures, and then prepare the other one of the above two structures, thus bringing many inconveniences to the fabrication of the superconducting quantum circuit. For example, it is often necessary to first prepare a capacitor plate C_{q} (or another superconducting element) to be connected with the superconducting quantum interference device (Squid), and then prepare a superconducting quantum interference device (Squid) connected with the capacitor plate C by a process of slant evaporation coating - oxidation - slant evaporation coating, and finally form a structure in which both are electrically connected, the process is lengthy, which greatly hinders the shortening of fabrication period and the improvement of process efficiency.

To this end, the present application provides a superconducting quantum circuit and a fabrication method thereof, as well as a quantum computer, to address the deficiencies in the prior art. The superconducting quantum circuit of the present application has a bottom electrode and a second superconducting element integrally connected, and the bottom electrode and the second superconducting element which are integrally connected can be synchronously fabricated by one patterning process during a fabrication process. After a barrier layer is formed on the surface of the obtained bottom electrode, one process such as evaporation coating is only required to obtain a top electrode which is partially overlapped with the barrier layer and electrically connected to the first superconducting element at one end. Then the superconducting quantum circuit in the present application can also be obtained. As described above, two evaporation coating processes are required in the related art, therefore, compared to the problems of lengthy fabrication process, long fabrication period and low process efficiency caused by the relatively independent structural forms of the superconducting quantum interference device and other superconducting elements in the prior art, the solution provided in the present application helps to shorten the fabrication process flow of the superconducting quantum circuits and realizes a more highly efficient process of fabrication.

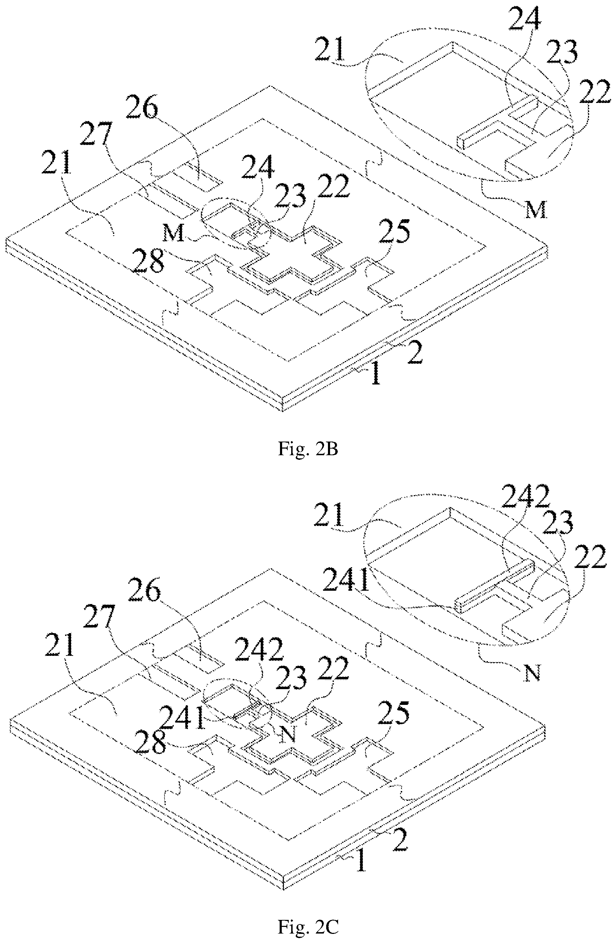

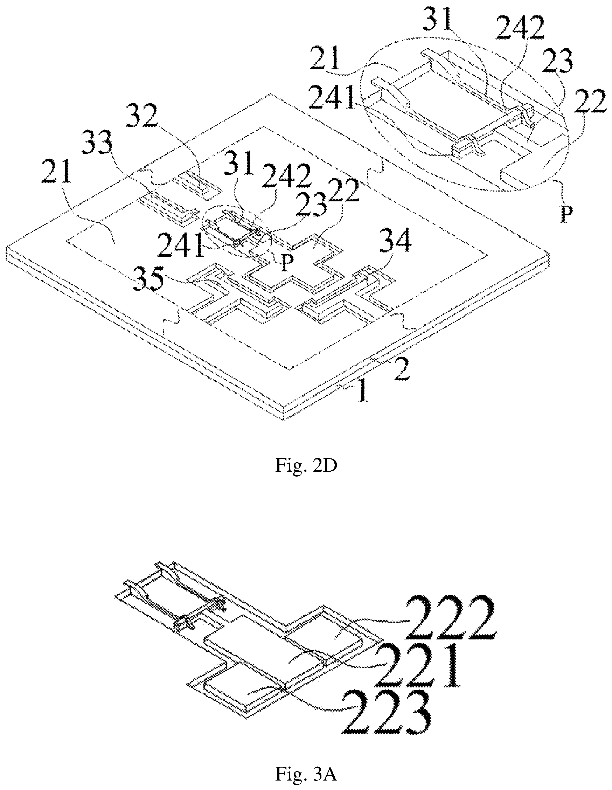

FIG. 2A, FIG. 2B, FIG. 2C, and FIG. 2D are schematic diagrams of a fabrication process of a superconducting quantum circuit provided by the present application, wherein FIG. 2D better illustrates the structure of a superconducting quantum circuit provided by the present application. For ease of understanding and comparison, M, N, and P are additionally schematically enlarged in the drawings of the present application.

Referring to FIG. 2D and in conjunction with FIGs. 2A, 2B and 2C, the present application provides a superconducting quantum circuit, which comprises a first superconducting element, a second superconducting element formed on a substrate 1, and a superconducting quantum interference device located between the first superconducting element and the second superconducting element, wherein the superconducting quantum interference device comprises:
a bottom electrode 241 integrally connected to the second superconducting element;
a barrier layer 242 located on the bottom electrode 241; and
a top electrode 31 that is electrically connected at one end to the first superconducting element and forms a partial overlapping area with the barrier layer 242 to obtain a Josephson junction at the overlapping area. Wherein the Josephson junction is a tunnel junction or other structure exhibiting a Josephson effect.

That is, the other end of the top electrode 31 is connected to the barrier layer 242.

Compared with the prior art, in the superconducting quantum circuit provided in the present application, the bottom electrode 241 of the superconducting quantum interference device is integrally connected with the second superconducting element, the bottom electrode 241 and the second superconducting element which are integrally connected are easy to be synchronously fabricated by one patterning process, and the bottom electrode 241 and the second superconducting element in this form have a good electrical connection performance. After the barrier layer 242 is formed on the surface of the bottom electrode 241, one process such as evaporation coating is only required to obtain the top electrode 31 which is partially overlapped with the barrier layer 242 and electrically connected to the first superconducting element at one end. As opposed to the process, that is, etching first to obtain a superconducting element, then performing a slant evaporation coating - oxidation - slant evaporation coating to obtain a superconducting quantum interference device, and finally forming a structure in which the superconducting element and the superconducting quantum interference device are electrically connected, caused by the relatively independent structural forms of the superconducting quantum interference device and other superconducting elements (e.g., capacitor plate C_{q} shown in FIG. 1) used in the superconducting quantum circuits of the related arts, the structure of the superconducting quantum circuit provided in the present application facilitates fabrication and helps to shorten the process flow and improve the fabrication efficiency.

Exemplarily, the bottom electrode 241 and the second superconducting element can be connected in direct contact or can be integrally connected by means of an electrical connection part 23 formed synchronously with the second superconducting element and the bottom electrode 241. That is, the electrical connection part 23 may be formed synchronously when the second superconducting element and the bottom electrode 241 are formed. That is, the second superconducting element, the bottom electrode 241 and the electrical connection part 23 are integrally connected.

In some embodiments of the present application, as shown in FIG. 2D and in combination with FIGs. 2A, 2B and 2C, the first superconducting element is a ground layer 21, and the second superconducting element is a capacitor plate 22 having a capacitance effect with respect to the ground layer 21. The capacitor plate 22 is not directly connected to the ground layer 21, and there is a proper gap between the capacitor plate 22 and the ground layer 21. The physical size of the gap is designed and determined according to the needs of the performance parameters of the quantum computing circuit. It should be noted that a capacitance C is formed between the capacitor plate 22 and the ground layer 21, thereby forming a circuit structure of qubits in the form of a single superconducting island, i.e., ground layer (GND) - superconducting quantum interference device - capacitor plate. In this embodiment, the capacitor plate 22 is surrounded by the ground layer 21 and separated from the ground layer 21 by a gap exposing the surface of the substrate 1, which may be a dielectric substrate such as silicon or sapphire. Exemplarily, the ground layer 21, the capacitor plate 22, and the superconducting quantum interference device are formed on a silicon substrate. The capacitor plate 22 and the ground layer 21 may be formed of superconducting materials exhibiting superconducting characteristics at a temperature equal to or lower than a critical temperature, such as aluminum, niobium or titanium nitride, which is not limited. Materials exhibiting superconducting characteristics at a temperature equal to or lower than a critical temperature may be used to form structures such as the ground layer 21, the capacitor plate 22, and the like.

FIG. 3A shows a schematic structural diagram of a first superconducting quantum circuit provided by the present application.

As an example, referring to FIG. 3A, and in comparison with FIGs. 2A to 2D, the capacitor plate 22 comprises at least two sub-capacitor plates and one of the at least two sub-capacitor plates is integrally connected to the bottom electrode 241. In this embodiment, the capacitor plate 22 is divided into a first sub-capacitor plate 221, a second sub-capacitor plate 222 and a third sub-capacitor plate 223 to form a plurality of capacitance effects, that is, a capacitance effect is formed between the first sub-capacitor plate 221 and the second sub-capacitor plate 222, and a capacitance effect is formed between the first sub-capacitor plate 221 and the third sub-capacitor plate 223. The first sub-capacitor plate 221 connected to the bottom electrode 241 adopts a structure integrally molded with the bottom electrode 241. In the structure with thin film limit, the contribution of the thickness to the capacitive effect can be ignored. The capacitor plate 22 in the qubit structure is divided and arranged into a plurality of sub-capacitor plates such that the capacitance in the qubit varies with the areas of the sub-capacitor plates. For example, the larger the area of a sub-capacitor plate is, the larger the capacitance of that sub-capacitor plate is. Accordingly, the capacitance of the qubits also varies with the number of sub-capacitor plates, and is related to the capacitance of each sub-capacitor plate, and the connection relationship between the sub-capacitor plates. For example, if the areas of the sub-capacitor plates are constant and the sub-capacitor plates are connected in series, the larger the number of sub-capacitor plates is, the smaller the capacitance of the qubit is. If the areas of the sub-capacitor plates are constant and the sub-capacitor plates are connected in parallel, the larger the number of sub-capacitor plates is, the larger the capacitance of the qubit is. The change in capacitance in the qubits in turn affects the resonant frequency of the qubits. Due to the need for coupling with pulse control lines, flux-modulation signal lines, read resonant cavities or other circuit structures or avoiding crosstalk, when the area on the substrate 1 covered by the capacitor plate 22 is limited, the capacitance value of the qubit can be reduced by dividing the capacitor plate 22, that is, a plurality of sub-capacitor plates are obtained by dividing the capacitor plate 22, and the plurality of sub-capacitor plates are connected in series, so as to reduce the capacitance value of the qubit. Exemplarily, it corresponds to a plurality of capacitors connected in series when the capacitor plate 22 is divided into a plurality of independent sub-capacitor plates, and the capacitance of the qubit is determined by these capacitors in series.

The superconducting quantum circuits provided in the present application are not limited to the embodiment in which the first superconducting element is the ground layer 21 and the second superconducting element is the capacitor plate 22 with a capacitive effect relative to the ground layer 21. Some other embodiments of the superconducting quantum circuits provided in the present application are described below in conjunction with the drawings.

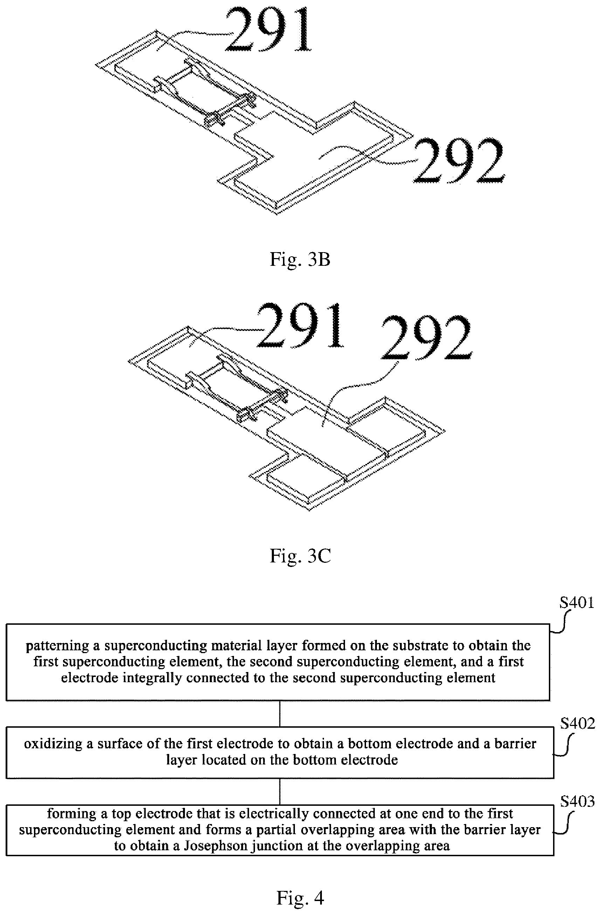

FIG. 3B shows a schematic structural diagram of a second superconducting quantum circuit provided by the present application.

In other embodiments of the present application, as shown in FIG. 3B, and in comparison with FIGs. 2A to 2D, a ground layer 21 is formed on the substrate 1, and each of the first superconducting element and the second superconducting element is a capacitor plate 22 having a capacitive effect with respect to the ground layer 21. For the purpose of distinction, as shown in FIG. 3B, the first superconducting element is a first capacitor plate 291 having a capacitive effect with respect to the ground layer 21, and the second superconducting element is a second capacitor plate 292 having a capacitive effect with respect to the ground layer 21, thereby forming a circuit structure of qubits in the form of having two superconducting islands, i.e., capacitor plate - superconducting quantum interference device - capacitor plate.

FIG. 3C shows a schematic structural diagram of a third superconducting quantum circuit provided by the present application.

Exemplarily, as shown in FIG. 3C and in comparison with FIGs. 2A to 2D, the first capacitor plate 291 and the second capacitor plate 292 each comprises at least two sub-capacitor plates, and one of the at least two sub-capacitor plates is integrally connected to the bottom electrode 241, or integrally connected to the top electrode 31. Schematically, for the purpose of distinction, see FIG. 3C, the second capacitor plate 292 is divided into a plurality of sub-capacitor plates to form a plurality of capacitance effects, and similarly, the first capacitor plate 291 can be divided into a plurality of sub-capacitor plates (not shown in the Figure). The sub-capacitor plate connected to the top electrode 31 adopts a structure integrally molded with the top electrode 31, and the sub-capacitor plate connected to the bottom electrode 241 adopts a structure integrally molded with the bottom electrode 241.

It should be noted that at least two sub-capacitor plates forming the same capacitor plate may be in the form of a structure separated from each other or in the form of a structure having an electrical connection.

In some embodiments of the present application, the superconducting quantum interference device comprises at least two top electrodes 31, wherein a different number of the top electrodes 31 results in a different number of Josephson junctions included in the superconducting quantum interference device, i.e., superconducting quantum interference devices with different structural forms and different magnetic flux sensitivity can be fabricated by adjusting the number of top electrodes 31. The at least two top electrodes 31 may be parallel or not parallel to each other. Exemplarily, the at least two top electrodes 31 forms at least two partial overlapping area with the barrier layer 242, and the overlapping areas are different from each other. The different overlapping areas realize different critical currents of formed Josephson junctions, so that a superconducting quantum interference device comprising non-symmetric Josephson junctions can be obtained, and thus the frequency spectrum of the superconducting quantum circuit has at least two magnetic flux insensitive points. Exemplarily, the superconducting quantum interference device comprises an odd number of the top electrodes 31, and the area of the overlapping area where each top electrode 31 partially overlaps with the barrier layer 242 is the same. This structural form also allows the frequency spectrum of the superconducting quantum circuit to have at least two magnetic flux insensitive points.

In some embodiments of the present application, the superconducting quantum circuit further comprises a third superconducting element fabricated in synchronization with the first superconducting element, the third superconducting element is located at a same surface as the first superconducting element and the second superconducting element, i.e., they are all located at the surface of the substrate 1. Exemplarily, the third superconducting element is at least one of a read resonant cavity 34, a pulse control line 32, a flux-modulation signal line 33, and a read signal line.

FIG. 4 shows a flowchart of a fabrication method of a superconducting quantum circuit provided by the present application.

As shown in FIG. 4 and in comparison with FIG. 2A, FIG. 2B, FIG. 2C, and FIG. 2D, a fabrication method for a superconducting quantum circuit is also provided in an embodiment of the present application. The superconducting quantum circuit comprises a first superconducting element and a second superconducting element formed on a substrate 1, and a superconducting quantum interference device located between the first superconducting element and the second superconducting element, the fabrication method comprises steps S401 to step S403, wherein:
Step S401: in this step, performing a patterning process on the superconducting material layer 2 formed on the substrate 1, i.e., patterning a superconducting material layer 2 formed on the substrate 1 to obtain the first superconducting element, the second superconducting element, and a first electrode 24 integrally connected to the second superconducting element.
Step S402, oxidizing a surface of the first electrode 24 to obtain a bottom electrode 241 and a barrier layer 242 located on the bottom electrode 241. It can be understood that in this step, the part of the first electrode 24 that is not oxidized forms the bottom electrode 241, and the oxide layer generated by the oxidization of the surface forms the barrier layer 242. It should be noted that in this step, a mask can be formed, by photoresist or the like, to cover an area that is not expected to be oxidized to avoid oxidation of the first superconducting element, the second superconducting element, and other structures.
Step S403, forming a top electrode 31 that is electrically connected at one end to the first superconducting element and forms a partial overlapping area with the barrier layer 242 to obtain a Josephson junction at the overlapping area.

In the fabrication method for a superconducting quantum circuit provided in the present application, a first superconducting element, a second superconducting element, and a first electrode are firstly fabricated synchronously by a patterning process, and the first electrode is integrally connected to the second superconducting element. After oxidizing a surface of the first electrode to form a bottom electrode and a barrier layer, one process such as evaporation coating is only required to obtain a top electrode which is partially overlapped with the barrier layer and electrically connected at one end to the first superconducting element. Compared to the way in the prior art of etching first to obtain a superconducting element, then performing a slant evaporation coating- oxidation- slant evaporation coating process to obtain a superconducting quantum interference device, and finally forming a structure in which both are electrically connected, the present application can reduce the times of evaporation coating, shorten the process flow and improve the fabrication efficiency.

It should be emphasized that the fabrication method for the superconducting quantum circuit provided in the present application does not impose any requirement on the angle of the evaporation coating in the fabrication process to obtain the Josephson junction. In the specific implementations, a slant evaporation can be used or a vertical evaporation relative to the surface to be evaporated can be used. Moreover, in the fabrication process for the superconducting quantum circuit, a plurality of Josephson junctions or a plurality of superconducting quantum circuits provided in the present embodiment can be fabricated synchronously. The bottom electrodes of a plurality of Josephson junctions and the top electrodes of a plurality of Josephson junctions are not limited to parallel structures.

In some embodiments of the present application, step S401, patterning the superconducting material layer 2 formed on the substrate 1 to obtain the first superconducting element, the second superconducting element, and the first electrode 24 integrally connected to the second superconducting element, specifically comprises steps S4011 to S4012, wherein:
Step S4011, forming a masking layer with a resist pattern on the superconducting material layer 2, wherein the resist pattern comprises a first resist pattern for defining the first superconducting element, a second resist pattern for defining the second superconducting element, and a third resist pattern for defining the first electrode 24, and the third resist pattern is connected to the second resist pattern. Exemplarily, the step of forming the masking layer with the resist pattern comprises: first coating a photoresist on the superconducting material layer 2 to form a photoresist layer, and then carrying out processes such as exposure and development on the photoresist layer. The pattern formed by the photoresist layer which has not been dissolved by the developing solution is a resist pattern, and the portion which has been dissolved by the developing solution is an etched pattern. The region on the superconducting material layer 2 to be etched is exposed through the etched pattern. It can be understood that the first resist pattern corresponds to the shape of the first superconducting element desired to be obtained, the second resist pattern corresponds to the shape of the second superconducting element desired to be obtained, and the third resist pattern corresponds to the shape of the first electrode 24 desired to be obtained.
Step S4012, etching a portion of the superconducting material layer 2 not covered by the resist pattern, to obtain the first superconducting element, the second superconducting element, and the first electrode 24, defined by the protection of the first resist pattern, the second resist pattern and the third resist pattern, wherein the first electrode 24 is integrally connected to the second superconducting element.

In some embodiments of the present application, step S403, forming the top electrode 31 that is electrically connected at one end to the first superconducting element, and forms the partial overlapping area with the barrier layer 242 to obtain the Josephson junction at the overlapping area, specifically comprises steps S4031 to S4032, wherein:
Step S4031, forming a masking layer with a deposition window on the superconducting material layer 2, wherein the deposition window comprises a first window for defining a deposited superconducting material to form the top electrode 31, and the first window exposes a portion of the first superconducting element as well as a portion of the barrier layer 242;
Step S4032, depositing a superconducting material and stripping off the masking layer, by using a vertical evaporation coating process, to obtain the top electrode 31 that is electrically connected at one end to the first superconducting element and forms the partial overlapping area with the barrier layer 242.

When performing a patterning process on the superconducting material layer 2 formed on the substrate 1, a first region 25 for fabricating a read resonant cavity, a second region 26 for fabricating a pulse signal line, a third region 27 for fabricating a flux-modulation signal line, and a fourth region 28 for fabricating a coupling structure between adjacent bits can be obtained synchronously by etching. Further, when forming the top electrode 31, it is also possible to synchronously obtain the read resonant cavity 34, the pulse signal line 32, the flux-modulation signal line 33, and the coupling structure 35 on the first region 25, the second region 26, the third region 27, and the fourth region 28, respectively, by using the deposition coating (which may be in the form of a vertical evaporation coating). It should be noted that the coupling structure 35 may be a capacitive coupling structure or a resonant cavity coupling structure, and the specific embodiments are not limited to this. In some implementations, the read resonant cavity 34, the pulse signal line 32, the flux-modulation signal line 33 and the coupling structure 35 may also be obtained, by etching, synchronously with the first superconducting element and the second superconducting element, when performing a patterning process on the superconducting material layer 2 formed on the substrate 1.

Also provided in an embodiment of the present application is a quantum computer comprising the superconducting quantum circuit as described in embodiments of the present application, or comprising the superconducting quantum circuit fabricated by the fabrication method as described in embodiments of the present application.

It should be noted herein that the superconducting quantum circuit in the above quantum computer is similar to the above structure and has the same beneficial effect as the above superconducting quantum circuit embodiment, and therefore will not be repeated. Regarding the technical details not disclosed in the quantum computer embodiments of the present application, those skilled in the art should refer to the description of the above superconducting quantum circuits, and for the sake of saving space, it will not be repeated herein.

The fabrication method for a superconducting quantum circuit provided by embodiments of the present application may require the deposition of one or more materials, such as superconductors, dielectrics, and/or metals. These materials may be deposited, depending on the material selected, using deposition processes such as chemical vapor deposition, physical vapor deposition (e.g., evaporation or sputtering) or epitaxial techniques, as well as other deposition processes. The fabrication process for a superconducting quantum circuit described in embodiments of the present application may require the removal of one or more materials from the device during the fabrication process. Depending on the material to be removed, the removal process may include, for example, a wet etching technique, a dry etching technique, or a lift-off process. The materials forming the circuit elements described herein may be patterned using known exposure (lithographic) techniques, e.g., photolithography or electron beam lithographic.

The above embodiments shown in the drawings illustrate in detail the structure, features and effects of the present application. The above mentioned are only the preferred embodiments of the present application, but the present application does not limit the scope of implementation as shown in the drawings. Any changes made in accordance with the concept of the present application, or modification of equivalent embodiments of equivalent changes that do not go beyond the spirit covered by the description and the drawings, shall be within the scope of protection of the present application.

## Claims

1. A superconducting quantum circuit, comprising a first superconducting element and a second superconducting element formed on a substrate, and a superconducting quantum interference device located between the first superconducting element and the second superconducting element, wherein the superconducting quantum interference device comprises:
a bottom electrode integrally connected to the second superconducting element;
a barrier layer located on the bottom electrode; and
a top electrode that is electrically connected at one end to the first superconducting element and forms a partial overlapping area with the barrier layer to obtain a Josephson junction at the overlapping area.

2. The superconducting quantum circuit according to claim 1, wherein the first superconducting element is a ground layer and the second superconducting element is a capacitor plate having a capacitive effect with respect to the ground layer.

3. The superconducting quantum circuit according to claim 2, wherein the capacitor plate comprises at least two sub-capacitor plates, and one of the at least two sub-capacitor plates is integrally connected to the bottom electrode.

4. The superconducting quantum circuit according to claim 1, wherein a ground layer is formed on the substrate, and each of the first superconducting element and the second superconducting element is a capacitor plate having a capacitive effect with respect to the ground layer.

5. The superconducting quantum circuit according to claim 4, wherein the capacitor plates each comprises at least two sub-capacitor plates, and one of the at least two sub-capacitor plates is integrally connected to the bottom electrode, or integrally connected to the top electrode.

6. The superconducting quantum circuit according to claim 3 or 5, wherein the at least two sub-capacitor plates are separated from each other.

7. The superconducting quantum circuit according to claim 1, wherein the superconducting quantum interference device comprises at least two top electrodes.

8. The superconducting quantum circuit according to claim 7, wherein the at least two top electrodes are parallel or not parallel to each other.

9. The superconducting quantum circuit according to any one of claims 1-5, 7-8, wherein the Josephson junction is a tunnel junction or other structure exhibiting a Josephson effect.

10. The superconducting quantum circuit according to any one of claims 1-5, 7-8, wherein the superconducting quantum circuit further comprises a third superconducting element located at a same surface as the first superconducting element and the second superconducting element.

11. The superconducting quantum circuit according to claim 10, wherein the third superconducting element is at least one of a read resonant cavity, a pulse control line, a flux-modulation signal line, and a read signal line.

12. A fabrication method for a superconducting quantum circuit, wherein the superconducting quantum circuit comprises a first superconducting element and a second superconducting element formed on a substrate, and a superconducting quantum interference device located between the first superconducting element and the second superconducting element, and the fabrication method comprises:
patterning a superconducting material layer formed on the substrate to obtain the first superconducting element, the second superconducting element, and a first electrode integrally connected to the second superconducting element;
oxidizing a surface of the first electrode to obtain a bottom electrode and a barrier layer located on the bottom electrode; and
forming a top electrode that is electrically connected at one end to the first superconducting element and forms a partial overlapping area with the barrier layer to obtain a Josephson junction at the overlapping area.

13. The fabrication method according to claim 12, wherein a step of patterning the superconducting material layer formed on the substrate to obtain the first superconducting element, the second superconducting element, and the first electrode integrally connected to the second superconducting element, comprises:
forming a masking layer with a resist pattern on the superconducting material layer, wherein the resist pattern comprises a first resist pattern for defining the first superconducting element, a second resist pattern for defining the second superconducting element, and a third resist pattern for defining the first electrode, and the third resist pattern is connected to the second resist pattern;
etching a portion of the superconducting material layer not covered by the resist pattern to obtain the first superconducting element, the second superconducting element, and the first electrode, wherein the first electrode is integrally connected to the second superconducting element.

14. The fabrication method according to claim 12, wherein a step of forming the top electrode that is electrically connected at one end to the first superconducting element and forms the partial overlapping area with the barrier layer, comprises:
forming a masking layer with a deposition window on the superconducting material layer, wherein the deposition window comprises a first window for defining a deposited superconducting material to form the top electrode, and the first window exposes a portion of the first superconducting element as well as a portion of the barrier layer;
depositing a superconducting material and stripping off the masking layer to obtain the top electrode that is electrically connected at one end to the first superconducting element and forms the partial overlapping area with the barrier layer.

15. A quantum computer, comprising the superconducting quantum circuit according to any one of claims 1-11, or comprising the superconducting quantum circuit fabricated by the fabrication method according to any one of claims 12-14.
